Europäisches Patentamt

European Patent Office

Office européen des brevets

(19)

(11) Veröffentlichungsnummer: **0 253 950 B1**

(12) **EUROPÄISCHE PATENTSCHRIFT**

(45) Veröffentlichungstag der Patentschrift: **17.07.91**

(51) Int. Cl.⁵: **H03M 1/06, H03M 1/74**

(21) Anmeldenummer: **87103742.0**

(22) Anmeldetag: **14.03.87**

(54) **Monolithisch integrierter Digital/Analog-Wandler.**

(30) Priorität: **21.07.86 EP 86109971**

(43) Veröffentlichungstag der Anmeldung:
**27.01.88 Patentblatt 88/04**

(45) Bekanntmachung des Hinweises auf die
Patenterteilung:
**17.07.91 Patentblatt 91/29**

(84) Benannte Vertragsstaaten:
**DE FR NL**

(56) Entgegenhaltungen:
FR-A- 2 349 874
US-A- 3 982 172
US-A- 4 225 816

DIGITAL PROCESSES, Band 5, Nr. 1/2, 1979,
Seiten 133-140, Georgi Publishing Co., St.
Saphorin, CH; P.E. DANIELSSON: "The glitch-
free D/A-converter"

(73) Patentinhaber: **Deutsche ITT Industries GmbH**
**Hans-Bunte-Strasse 19 Postfach 840**
**W-7800 Freiburg i.Br.(DE)**

(72) Erfinder: **Mehrgardt, Sönke, Dr.**
**Häglestrasse 26**
**W-7806 March(DE)**
Erfinder: **Theus, Ulrich, Dr.**
**Schönbergstrasse 5b**
**W-7803 Gundelfingen(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Bei der monolithischen Integration von hochgenauen Stromteilern mit Stromquellen für die Massenherstellung von monolithisch integrierten Festkörperschaltungen besteht die Schwierigkeit der Herstellungsschwankungen der Stromquellen, welche bekanntlich in Form der Kollektor-Emitter-Strecken von Bipolartransistoren einer sogenannten Strombank realisiert werden können, wobei die Basiselektroden auf ein gemeinsames Potential gelegt sind. Diese Schwierigkeit wurde bei einem monolithisch integrierten Digital/Analog-Wandler (im folgenden kurz "D/A-Wandler" genannt) für eine 14-stellige Dualzahl mit Bipolartransistoren nach "Electronics" vom 16. 6.1983, Seiten 130 bis 134, und "Electronic Components and Applications" Band 2, Nr. 4 (Aug. 1980) Seiten 235 bis 241, durch Verwendung eines integrierten Stromteilers im wesentlichen dadurch behoben, daß die Ströme einer Mehrzahl von Stromquellen zyklisch mittels eines Schieberegisters rotierend auf drei Stromwege geschaltet werden, wovon der erste und zweite den halben Strom des dritten Stroms erhält. Durch Kaskadenschaltung einer Mehrzahl solcher Stromteiler kann ein hochgenauer monolitisch integrierter D/A-Wandler realisiert werden.

Die Erfindung macht ebenfalls von diesem Prinzip des dynamischen "element matching" Gebrauch, verwendet jedoch nicht den oben erwähnten Stromteiler des bekannten D/A-Wandlers. Da dieser in Kaskade geschaltete Stromteiler verwendet, ist für jeden Stromteiler ein RC-Siebglied mit von außen zugeschalteten Kondensatoren erforderlich.

Aus FR-A 2 349 874 ist ein monolithisch integrierter Digital/Analog-Wandler bekannt, bei dem durch die zyklische Umschaltung von möglichst gleichen Stromquellen die Linearität der Wandlerkennlinie verbessert wird. Als zyklische Schiebenetzwerke dienen hierbei rückgekoppelte Schieberegister, die mindestens eine solche Anzahl von Stufen aufweisen, daß die Anzahl dem größtmöglichen Wert des umzuwandelnden digitalen Eingangssignals entspricht. Dabei schaltet jede Schieberegisterstufe entsprechend ihrem Logikzustand über einen Bitschalter ihre zugehörige Stromquelle auf eine erste oder zweite gemeinsame Stromsammelschiene. Dabei stellt der Summenstrom auf der einen gemeinsamen Stromsammelschiene das gewünschte analoge Ausgangssignal dar. Die Frequenz des Schieberegistertaktes ist von der Anzahl der Schieberegisterstufen und der Frequenz des Datentaktes, die um ein Vielfaches niedriger ist, abhängig. Damit jede Stromquelle möglichst gleichmäßig an der Stromsummierung beteiligt ist, müssen die Perioden des Schiebetaktes untereinander möglichst gleichlang sein, vgl. auch den Oberbegriff des Anspruchs 1.

Aus "Digital Processes", Bd. 5, Nr.1/2, 1979, Seiten 133 - 140 ist ein Digital/Analog-Wandler bekannt, bei dem das digitale Eingangssignal, dessen Stellen gewichtet sind, vor der Digital-Analogumsetzung mittels eines Codewandlers in einen entsprechenden Thermometercode umgesetzt wird. Damit soll verhindert werden, daß beim Datenwechsel von höherwertigen Stellen des gewichteten Codes Störsignale erzeugt werden, die auch als "Glitch"-Signale bezeichnet werden.

Aufgabe der Erfindung ist daher, einen verbesserten, monolithisch integrierbaren D/A-Wandler mit zyklischer Stromquellenumschaltung anzugeben, der mit Daten in gewichtetem Binärcode ansteuerbar ist, keine RC-Siebglieder benötigt und der insbesondere in MOS-Technik herstellbar ist, ohne daß er eine wesentlich höhere Betriebsspannung als 5 V benötigt. Bei einer Realisierung der bekannten Anordnung in MOS-Technik ist nämlich aufgrund der Kaskadenschaltung eine Betriebsspannung von mehr als 25 V erforderlich.

Die Erfindung geht von den Gedanken aus, eine Anzahl möglichst gleicher Stromquellen so nacheinander mittels eines Schiebenetzwerks, das mit der Taktfrequenz fc getaktet wird, leitend anzusteuern, daß sich im Mittel die Toleranzen dieser Stromquellen auslöschen.

Die oben genannte Aufgabe wird durch die im kennzeichnenden Teil des Anspruchs 1 angegebene Ausbildung gelöst.

Es wird also das mehrstellige Eingangssignal, dessen Code zwar beliebig, in der Regel jedoch meist ein Dualzahlcode sein dürfte, mittels eines entsprechenden Codewandlers in einen geeigneten binären Ausgangscode umgewandelt, mit dem über Bitschalter soviele Stromquellen leitend angesteuert werden, wie dem Zahlenwert des Eingangssignals entsprechen. Ein solcher Code ist vorzugsweise der Thermometercode. Bei einem allgemeineren Code ist zwar die Anzahl erster Binärzustände, bei denen die Bitschalter einschalten, gleich wie die Anzahl erster Binärzustände beim entsprechenden Thermometercode, ihre Anordnung innerhalb des Codewortes ist jedoch im Gegensatz zum Thermometercode beliebig.

Die Erfindung wird in folgenden anhand der Zeichnung näher erläutert,

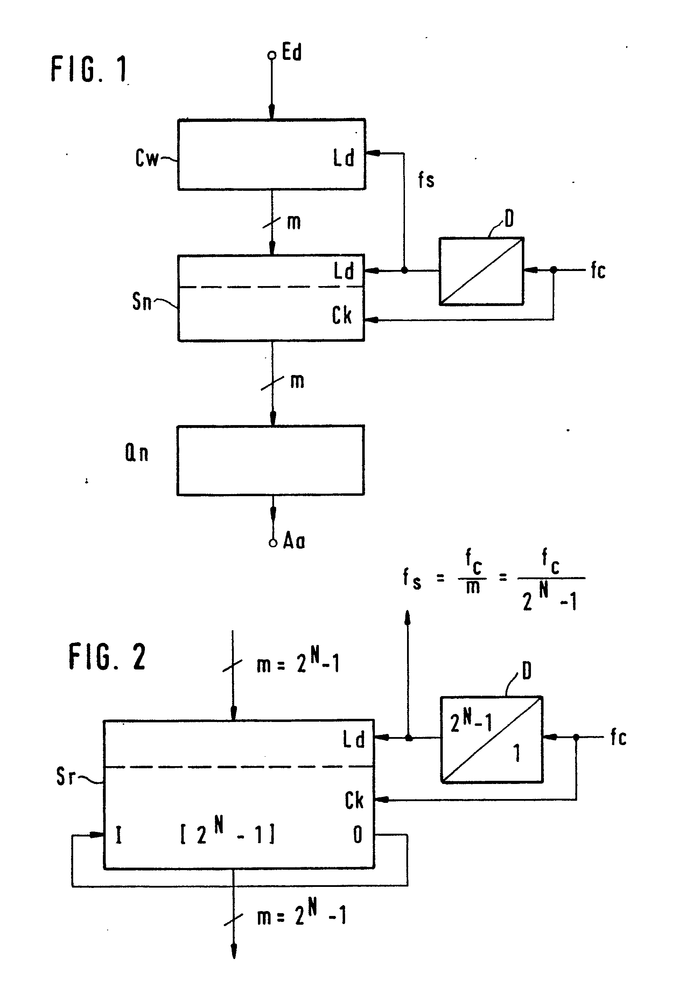

deren Fig. 1

das Prinzipschaltbild eines Ausführungsbeispiels des Digital/Analog-Wandlers nach der Erfindung zeigt,

deren Fig. 2

eine bevorzugte Ausführungsform der zyklischen Stromumschaltung betrifft,

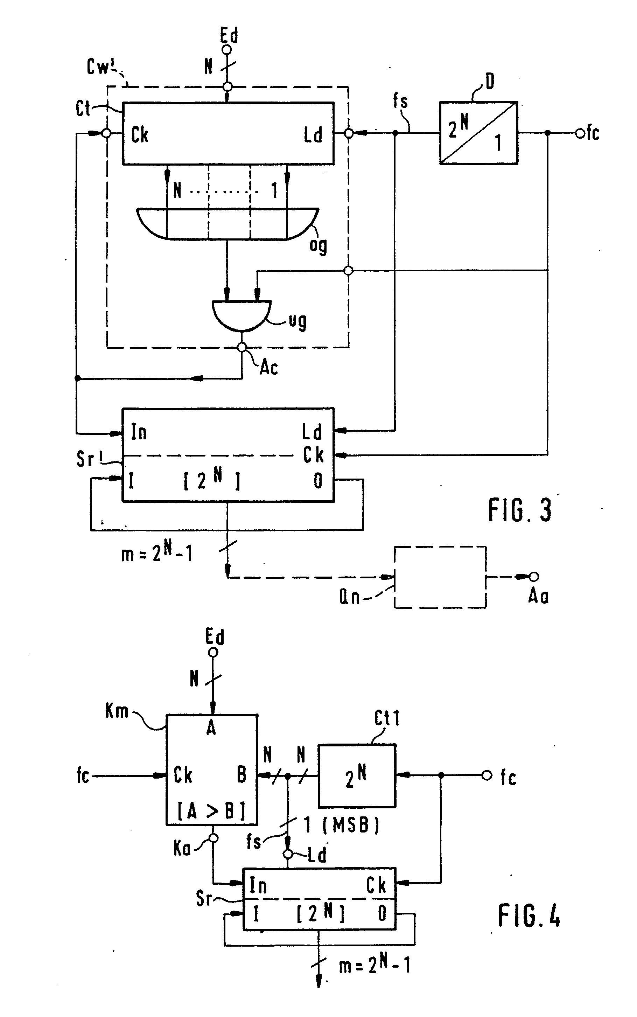

deren Fig. 3 und 4

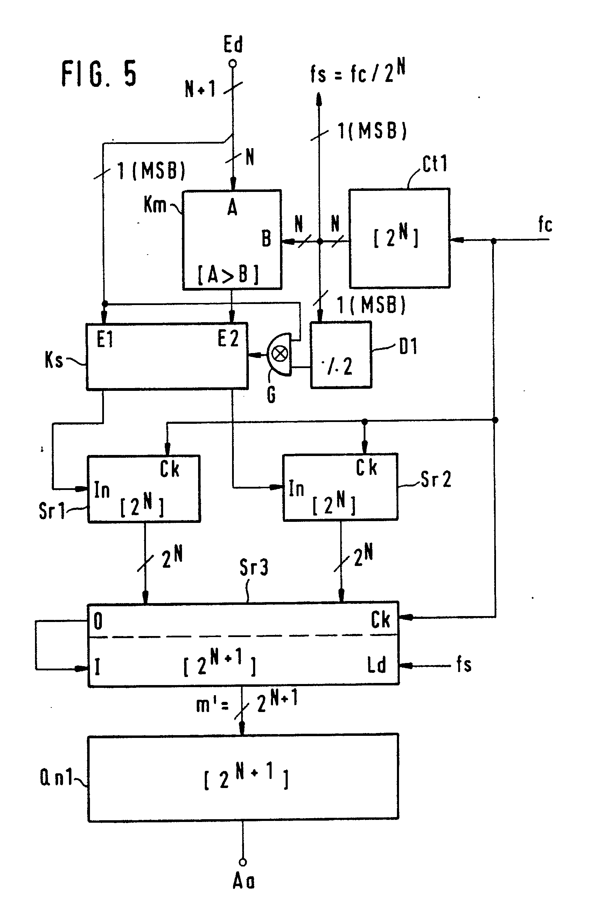

die Blockschaltbilder von Codewandlern zur Wandlung eines dualzahligen Eingangssignals in den Thermometercode bedeuten und

deren Fig. 5

das Blockschaltbild eines D/A-Wandlers für eine Dualzahl mit N + 1 Stellen zeigt.

Entsprechend dem Prinzipschaltbild des Ausführungsbeispiels der Fig. 1 liegt das Eingangssignal Ed am Eingang des Codewandlers Cw, der mit der Abtastfrequenz fs am Ladeeingang Ld aufgetastet wird und das Eingangssignal Ed in ein Signal im sogenannten Thermometercode umwandelt. Am Ausgang des Codewandlers Cw entsteht also in paralleler Form eine Folge von ersten, d.h. stromeinschaltenden Binärzuständen, deren Anzahl dem Zahlenwert des Eingangssignals Ed gleich ist. Wenn dabei der unabhängig vom Eingangscode maximal zuführbare Zahlenwert des Eingangssignals Ed "m" ist, dann ist "m" auch die Anzahl der parallelen Ausgangsleitungen des Codewandlers Cw und "m" ist auch die Anzahl der maximal ansteuerbaren Stromquelleneinheiten des Stromquellenteils Qn.

Der Thermometercode wird über das zyklische Schiebenetzwerk Sn auf die Stromquelleneinheiten des Stromquellenteils Qn gegeben, wodurch die Steuerelektroden der Bitschalter der Stromquelleneinheiten rotierend angesteuert werden. Das Analogsignal wird am Ausgang Aa des Stromquellenteils Qn nach Summierung der Stromquelleneinheitsströme erhalten. Aus dem Taktsignal mit der Taktfrequenz fc, welches das zyklische Schiebenetzwerk Sn taktet, erzeugt der Teiler D das Abtastsignal mit der Abtastfrequenz fs, mit dem die m Eingänge des zyklischen Schiebenetzwerks Sn leitend gesteuert werden. Die Teilungszahl wird später noch genau bestimmt, sie liegt aber in der Größenordnung von m.

Als zyklisches Schiebenetzwerk Sn wird z.B. ein Barrel-Shifter - vergl. EP-A 0 170 493 - entsprechend dem bekannten Stand der Technik verwendet.

Bei dem Barrel-Shifter wird durch elektrische Schaltelemente die Verbindung einer Anzahl von Eingangsanschlüssen zu einer gleichgroßen Anzahl von Ausgangsanschlüssen zyklisch umgeschaltet, wobei die Mehrzahl der internen Schaltverbindungen sich dabei parallel jeweils gleichsinnig um nur eine Position verändert. Der dabei überzählige Ausgangsanschluß auf der einen Seite des Barrel-Shifters wird mit dem freiwerdenden Ausgangsanschluß auf der anderen Seite verbunden und bewirkt so die zyklische Umschaltung. Die Eingabe der einzelnen Shift-Positionen erfolgt meist binär codiert, so daß statt der Ansteuerung über einen Teiler eher ein Zähler mit codierten Ausgangssignalen vorzuziehen ist.

Ohne das zyklische Schiebenetzwerk, also bei rein statischer Aussteuerung entfiele der Vorteil der rotierenden Ansteuerung der m Stromquelleneinheiten, so daß die Linearität des D/A-Wandlers allein durch die relative Gleichheit der m Stromquelleneinheiten wie bei einem üblichen D/A-Wandler bestimmt wäre. Bei einer monolithischen Integration ohne Abgleich muß jedoch für die einzelnen Stromquelleneinheiten mit Toleranzen von typisch 1% gerechnet werden, so daß eine Linearitätsforderung von beispielsweise 0,01% ohne besonderen Aufwand nicht eingehalten werden kann. Im Prinzip kann man durch die rotierende Ansteuerung der Stromquelleneinheiten mit der höher als die Abtastfrequenz fs liegenden Taktfrequenz fc den Linearitätsfehler auf Null bringen.

Von besonderem Interesse für den Toleranzausgleich hierbei ist, wenn das Verhältnis von Taktfrequenz fc zu Abtastfrequenz fs gleich oder ein ganzzahliges Vielfaches der Stufenanzahl des Schiebenetzwerkes Sn und damit auch der Anzahl der nacheinander einschaltbaren Stromquelleneinheiten ist. In diesem Fall werden im Abtastfrequenzintervall alle Stromquelleneinheiten genau gleich oft betätigt und der auf den Toleranzen der Stromquelleneinheiten beruhende Linearitätsfehler wird dabei innerhalb eines Abtasttaktes völlig eliminiert. In diesem speziellen Fall kann das zyklische Schiebenetzwerk Sn durch ein rückgekoppeltes Schieberegister Sr realisiert werden. In Fig. 2 ist dies für eine als Eingangssignal Ed zugeführte Dualzahl mit N Stellen veranschaulicht.

Das rückgekoppelte Schieberegister Sr in Fig. 2 ist aus m = $2^N$-1 einzelnen Schiebestufen aufgebaut, die m = $2^N$-1 parallele Eingangs- und ebensoviele parallele Ausgangsanschlüsse aufweisen, wobei letztere mit den entsprechenden Bitschalteranschlüssen des Stromquellenteils zu verbinden sind. Nach einen vollen Zyklus, also nach m = $2^N$-1 Schiebetakten wird mittels des Abtastsignals am Ladeeingang Ld ein neues Thermometercodewort in das rückgekoppelte Schieberegister Sr eingeschrieben. Das Abtastsignal mit der Abtastfrequenz fs ist dabei durch das Ausgangssignal des Teilers D realisiert, dessen Eingangssignal das Taktsignal und dessen Teilungszahl $2^N$-1 ist. Der Ausgang 0 der letzten Schieberegisterstufe ist mit dem Eingang I der ersten Schieberegisterstufe verbunden und bildet somit die Rückkoppelung des Schieberegisters Sr.

Ganz besonders vorteilhaft ist es, wenn dabei das Frequenzverhältnis von Taktfrequenz fc zu Abtastfrequenz fs eine glatte Zweierpotenz ist, z.B. fc/fs = $2^N$, weil dann der Teiler D durch einen einfachen Binärteiler, im Beispiel ein N-stelliger Teiler aus N binären Teilerstufen realisierbar ist, vgl. Fig. 3. Das rückgekoppelte Schieberegister Sr' enthält dabei $2^N$ Stufen, aber nur $2^N$-1 Bitschalterausgänge. Eine der Schieberegisterstufen dient somit allein der Taktanpassung, ohne einen Bitschalter zu steuern. Der Ausgang 0 der letzten Schieberegisterstufe ist wie in Fig. 2 mit dem Eingang I der ersten Schieberegisterstufe verbunden, um die Rückkopplung des Schieberegisters Sr' zu verdeutlichen.

Die Erzeugung eines geeigneten Codes aus einen dualen N-stelligen Eingangssignal Ed für das rückgekoppelte Schieberegister Sr ist einfach, weil die Reihenfolge der Binärzustände beliebig sein kann, wenn nur die Anzahl der stromeinschaltenden Binärzustände gleich dem eingegebenen Zahlenwert ist. Beispielsweise ist jeder Eingangsstelle ein ihrer Wertigkeit entsprechende gleiche Anzahl von Ausgangsstellen zugeordnet, die je nach dem binären Zustand dieser Eingangsstelle gemeinsam den einen oder anderen Binärzustand aufweisen. Dies leistet beispielsweise ein nichtinvertierender Impedanzwandler je Eingangsstelle, dessen Ausgang $2^k$-fach verzweigt ist, wobei $O \leq k \leq N$ durch die jeweilige Stelle mit der Wertigkeit $2^k$ innerhalb des dualen Eingangssignals Ed gegeben ist.

Fig. 3 zeigt das Blockschaltbild eines Codewandlers Cw', der die Erzeugung des Thermometercodes aus einer als Eingangssignal Ed zugeführten N-stelligen Dualzahl ohne ein aufwendiges Logiknetzwerk ermöglicht. Der Codewandler Cw' enthält dabei den voreinstellbaren Rückwärtszähler Ct, der mittels des Abtastimpulses am Ladeeingang Ld das Eingangssignal Ed in den Zählerstand übernimmt. Ferner enthält der Codewandler das UND-Gatter ug und das ODER-Gatters og. Bei Betrieb der beiden Gatter in positiver Logik liegt am Ausgang z. B. des UND-Gatters ug dann der positive Pegel H (= H-Pegel) zweier Binärpegel H, L, wenn an allen Eingängen des UND-Gatters ug ebenfalls H-Pegel liegen.

Die Zählimpulse am Takteingang Ck des Rückwärtszählers Ct sind die über das UND-Gatter ug als Torschaltung geführten Impulse des Taktsignals, die den Rückwärtszähler Ct solange mit der Taktfrequenz fc rückwärts zählen lassen, bis der Zählerstand Null erreicht ist. Dieser Nullzustand wird durch das ODER-Gatter og erkannt, weil in diesem Fall alle mit den N Zählerstandsausgängen verbundene N Eingänge des ODER-Gatters og jeweils auf dem logischen L-Pegel liegen, so daß das Ausgangssignal des ODER-Gatters og vom vorherigen H-Pegel auf den L-Pegel wechselt und damit das UND-Gatter ug für das Taktsignal sperrt.

Der Ausgang des UND-Gatters ug ist auch der Ausgang Ac des Codewandlers Cw' und ist ferner mit dem seriellen Eingang In des rückgekoppelten Schieberegisters Sr' verbunden. Die dort innerhalb eines Abtasttaktes abgelegte Impulsfolge aus dem Codewandlerausgang Ac entspricht dem Thermometercode des Eingangssignals Ed.

Bei N = 4 und beispielsweise einer Dualzahl 1111 werden also soviele Impulse über den Serieneingang In in das Schieberegister Sr' eingegeben, bis alle 15 Speicherstellen, welche die Bitschalter ansteuern, auf H-Pegel liegen, dann ist dieser Eingabevorgang beendet. Beim nächsten eintreffenden Impuls des Abtastsignals am Ladeeingang Ld wird der Rückwärtszähler Ct mit dem Eingangssignal Ed neu geladen. Gleichzeitig wird aus dem seriellen Eingangsteil des rückgekoppelten Schieberegisters Sr' der Dateninhalt in den eigentlichen Schiebeteil übernommen. Diese Übernahmesteuerung erfolgt ebenfalls durch das Abtastsignal fs, das dem Ladeeingang Ld des Schieberegisters Sr' zugeführt ist.

In der Fig. 4 ist das Blockschaltbild eines anderen Codewandlers zur Erzeugung des Thermometercodes dargestellt. Dieser unterscheidet sich vom Codewandler Cw' der Fig. 3 dadurch, daß er anstelle des dualen N- stelligen Rückwärtszählers Ct den digitalen Komparator Km mit einen N-stelligen Substrahendeingang B und mit einen N-stelligen Minuendeingang A, wobei dem letzteren das N-stellige Eingangssignal Ed dual zugeführt ist, enthält. Anstelle des N-stelligen Binärteilers D von Fig. 3 dient der N-stellige Binärzähler Ct1, dessen N Zählerstandausgänge mit den zugehörigen N Stellen des Substrahendeingangs B des digitalen Komparators Km verbunden sind. Der Komparator Km ersetzt also den dualen N-stelligen Rückwärtszähler Ct der Fig. 3 und ermöglicht über seinen Ausgangsanschluß Ka solange das serielle Einlesen von Impulsen mit der Taktfrequenz fc in das $2^N$-stellige Schieberegister Sr, wie der am Minuendeingang A anliegende Zahlenwert größer als derjenige ist, der am Subtrahendeingang B anliegt. Das Abtastsignal mit der Abtastfrequenz fs ist dabei das MSB-Signal (MSB = most significant bit) des dualen N-stelligen Zählers Ct1.

Die Fig. 5 zeigt schließlich einen D/A-Wandler mit einer Weiterbildung der Schaltungsanordnung nach Fig. 4. Dieser D/A-Wandler der Fig. 5 liefert für ein duales (N+1)-stelliges-Eingangssignal unter Verwendung des Codewandlers der Fig. 4, des Kreuzschalters Ks, des ersten und des zweiten $2^N$-stelligen-SchieberegistersSr1, Sr2 und des dritten $2^{N+1}$-stelligen-Schieberegisters Sr3, das in sich rückgekoppelt ist, am Ausgang Aa ein digital-analog gewandeltes Signal mit einer Auflösung, die doppelt so groß (6db) wie diejenige eines D/A-Wandlers mit Codewandlern der Fig. 3 oder 4 ist.

Der Gewinn an Auflösung und damit die Verbesserung des Signal-Rauschverhältnisses wird dadurch erreicht, daß die Stellenzahl des dualen Eingangssignals Ed gegenüber Fig. 3 oder 4 um eine Stelle erhöht ist. Dies ist an und für sich eine triviale Erkenntnis, die jedoch dadurch bedeutsam wird, daß das Verhältnis von Taktfrequenz zu Abtastfrequenz fc/fs = m als ganzzahligen Proportionalitätsfaktor mindestens den maximal möglichen Zahlenwert m des Eingangssignals Ed enthält und somit bei fester Abtastfrequenz fs die Taktfrequenz fc mit erhöter Auflösung in die Höhe treibt. Für die Taktfrequenz sind aber schaltungstechnische Grenzen gegeben.

Das Ausführungsbeispiel nach Fig. 5 erlaubt die Ausdehnung auf duale (N + 1)-stellige Eingangssignale, auch wenn mit N Stellen nach Fig. 3 oder 4 die maximal zulässige Taktfrequenz fc eigentlich erreicht ist. Das rückgekoppelte Schieberegister wird dabei für den Einschreibvorgang in zwei gleiche Abschnitte geteilt, die aber zugleich eingelesen werden. In den ersten Abschnitt gelangen entsprechend der MSB-Stelle des Eingangssignals Ed lauter H- oder L-Pegel, während in den zweiten Abschnitt entsprechend Fig. 4 diejenige Dualzahl in Form des Thermometercodes eingelesen wird, die übrig bleibt, wenn vom dualen Eingangssignal Ed die MSB-Stelle abgestreift ist.

Während eines Abtasttaktes führt das rückgekoppelte Schieberegister nur einen halben Umlauf aus, das bedeutet, daß der Inhalt der beiden Abschnitte gegeneinander getauscht ist. Somit müssen beim erneuten Einschreibvorgang, der ja an die Abtastfrequenz fs gekoppelt ist, die der MSB-Stelle entsprechenden H- oder L-Pegel in den zweiten Abschnitt geschrieben werden. In den ersten Abschnitt gelangt der Thermometercode des von der MSB-Stelle abgestreiften Eingangssignals Ed. Bei konstantem Eingangssignal Ed erfolgt so nach einen vollen Umlauf bzw. Zwei Abtasttakten der vollständige Toleranzausgleich der Stromquelleneinheiten im Stromquellenteil Qn1. Bei sich ändernden Eingangssignalen Ed ist der Ausgleich nicht mehr vollständig, das resultierende Störsignal liegt aber weit über der Eingangssignalfrequenz und ist somit leicht herausfilterbar.

Die Steuerung des Einschreibvorgangs der beiden Schieberegisterabschnitte erfolgt mittels eines Kreuzschalters, dessen Schalterstellung mit jedem Abtasttaktimpuls umgeschaltet wird. Ein einfaches Beispiel für die Kreuzumschaltung zeigt Fig. 5, bei der der Kreuzschalter Ks jeweils nur zwei Signalpfade für Impulse umschaltet, die in serieller Form in das erste bzw. zweite $2^N$stellige Schieberegister Sr1, Sr2 als Zwischenspeicher gelangen. Von dort gelangen sie parallel in die beiden Abschnitte des dritten rückgekoppelten $2^{N+1}$-stelligen Schieberegisters Sr3. Die Übernahme in dieses erfolgt durch das Abtastsignal fs am Ladeeingang Ld. Durch den abschnittsweisen Ladevorgang hat das dritte Schieberegister Sr3 $2^{N+1}$ Eingänge und auch ebensoviele Bitschalterausgänge m', obgleich im Stromquellenteil Qn1 maximal nur $2^{N+1}$-1 Stromquelleneinheiten entsprechend der größtmöglichen Zahl m = $2^{N+1}$-1 des Eingangssignals Ed gleichzeitig geschaltet werden.

Ein MSB-Sprung des Eingangssignals Ed kann infolge der Kreuzumschaltung zu einer mehr oder weniger einseitigen Belegung des dritten Schieberegisters Sr3 führen. Diesen Fehler vermeidet das XOR-Gatter G in Fig. 5, weil die jeweilige Stellung des Kreuzschalters Ks außer von dem heruntergeteilten Abtastsignal fs auch noch von der MSB-Stelle des Eingangssignals Ed abhängig ist. Die beiden Abschnitte des dritten Schieberegister Sr3 werden somit bei Signalen, die um den MSB-Wert herum liegen, gleichmäßiger und damit vorteilhafter in die Stromquellenrotation einbezogen.

Die Funktion des in Fig. 5 dargestellten Kreuzschalters Ks erklärt sich wie folgt: Während das MSB-Signal des Eingangssignals Ed an dem ersten Eingang E1 des Kreuzschalters Ks liegt, erhält dessen zweiter Eingang E2, wie bei der Anordnung der Fig. 4 solange Impulse, wie das um das MSB verringerte Eingangssignal Ed am Minuendeingang A größer als das Eingangssignal am Subtrahendeingang B ist. Letzteres N-stellige Signal bildet der N-stellige Zähler Ct1 aus dem Taktsignal mit der Taktfrequenz fc, wobei das MSB als Abtastsignal mit der Abtastfrequenz fs verwendet wird und zur Gewinnung des Umschalttaktes des Kreuzschalters KS mittels des ersten Teilers D1 dient. Dieser teilt die MSB-Taktfrequenz durch den Faktor 2.

Die Auslegung der Teiler, der Zähler, der Schieberegister und des Komparators kann in einer dem Fachmann bekannten Weise vorgenommen werden. Ein besonderer Vorteil des Digital-Analog-Wandlers nach der Erfindung ist bei der Auslegung mit Isolierschicht-Feldeffekttransistoren gegeben, da eine Kaskadenschaltung entsprechend dem eingangs genannten Stand der Technik vermieden ist, so daß eine Betriebsspannung von lediglich 5 V bis 6 V möglich ist. Ein weiterer Vorteil ist, daß die beim Stand der Technik erforderlichen Siebkondensatoren als Teil der Kaskadenschaltung entfallen.

Die Erfindung wird z.B. als Teilschaltung in einem hochauflösenden Audio-D/A-Umsetzer verwendet und ermöglicht damit eine Auflösung, die einer 16-stelligen Dualzahl (16 Bit) entspricht.

**Patentansprüche**

1. Monolithisch integrierter Digital/Analog-Wandler ( = D/A-Wandler) mit
   - einer Anzahl von Eingängen, die von einem Abtastsignal gesteuert ein mehrstelliges digitales Eingangssignal (Ed) im Takt dieser Abtastfrequenz (fs) übernehmen,
   - Stromquelleneinheiten, von denen eine dem Wert des digitalen Eingangssignals (Ed) entsprechende Anzahl mittels Bitschalter auf eine Summierstufe geschaltet sind, deren Ausgang (Aa) der Ausgang des D/A-Wandlers ist,
   - einem Taktsignal, dessen Taktfrequenz (fc) ein Mehrfaches der Abtastfrequenz (fs) ist und das innerhalb einer Abtastperiode nacheinander alle vorhandenen Stromquelleneinheiten so umschaltet, daß diese in dieser Abtastperiode genau gleichlang eingeschaltet sind, und einem zyklischen Schiebenetzwerk (Sn), das mindestens m Ausgänge aufweist, wobei m die größtmögliche Zahl des Eingangssignals (Ed) ist und jeweils die Steuerelektrode des Bitschalters einer Stromquelleneinheit von der zugeordneten Stufe des Schiebenetzwerkes (Sn) angesteuert ist, dadurch gekennzeichnet,

- daß das Eingangssignal (Ed) an den Eingängen eines Codewandlers (Cw) liegt, der es in einen Code mit einer, insbesonders kontinuierlichen, Anzahl von ersten Binärzuständen umwandelt, deren Anzahl gleich dem Zahlenwert des Eingangssignals (Ed) ist,
- daß die Ausgänge des Codewandlers (Cw) mit den Eingängen des zyklischen Schiebenetzwerkes (Sn) verbunden sind,
- daß das zyklische Schiebenetzwerk (Sn) mindestens m Eingänge aufweist und
- daß die Anzahl der Schiebestufen des zyklischen Schiebenetzwerkes (Sn) gleich dem Verhältnis aus Taktfrequenz (fc) zu Abtastfrequenz (fs) ist, wobei letztere durch Frequenzteilung mittels eines Teilers (D) aus dem Taktsignal erzeugt ist.

2. Monolithisch integrierter D/A-Wandler nach Anspruch 1, wobei das zyklische Schiebenetzwerk (Sn) in bekannter Weise durch ein rückgekoppeltes Schieberegister (Sr) realisiert ist.

3. Monolithisch integrierter D/A-Wandler nach Anspruch 2, dadurch gekennzeichnet,
- daß das Verhältnis aus Taktfrequenz (fc) zu Abtastfrequenz (fs) einer Zweierpotenz $2^N$ entspricht,
- daß der Teiler (D) ein Binärteiler mit N Teilerstufen ist und
- daß das Schieberegister (Sr) aus $2^N$ Schiebestufen besteht.

4. Monolithisch integrierter D/A-Wandler nach Anspruch 3, dadurch gekennzeichnet,
- daß für ein duales Eingangssignal (Ed) mit N Stellen der Codewandler (Cw') einen dualen N-stelligen Rückwärtszähler (Ct) enthält, der mittels des Abtastsignals auf den Zahlenwert des Eingangssignals (Ed) gesetzt wird und solange mittels logischer Schaltungen mit der Taktfrequenz (fc) getaktete Impulse an einen Serieneingang (In) des Schieberegisters (Sr') abgibt, bis der Rückwärtszählerstand Null ist,
- daß diese seriell am Eingang (In) des Schieberegisters (Sr') eingegebene Impulsfolge vom Abtastsignal gesteuert parallel in den eigentlichen vom Taktsignal getakteten Schiebeteil übernommen wird.

5. Monolithisch integrierter D/A-Wandler nach Anspruch 3, gekennzeichnet durch folgende Merkmale:
- der Codewandler besteht aus einem mit der Taktfrequenz (fc) getakteten Komparator (Km) mit einem N-stelligen Subtrahendeingang (B) und einem N-stelligen Minuendeingang (A), dem das duale N-stellige Eingangssignal (Ed) zugeführt ist,
- der Teiler besteht aus einem dualen N-stelligen Zähler (Ct1), der mit der Taktfrequenz (fc) getaktet ist und dessen Zählerstand den Subtrahendeingang (B) des Komparators (Km) speist, wobei desssen Ausgang (Ka) solange Impulse mit der Taktfrequenz (fc) an einen Serieneingang (In) des Schieberegisters (Sr) abgibt, solange der Zahlenwert des am Minuendeingang (A) anliegenden Eingangssignals (Ed) größer als der Zahlenwert des am Subtrahendeingang (B) anliegenden Zählerstandes ist,
- die parallele Übernahme der in den Serieneingang (In) übertragenen Impulsfolge in den eigentlichen $2^N$-stufigen Schiebeteil des Schieberegisters (Sr) wird durch das Abtastsignal am Ladeeingang (Ld) gesteuert, und
- der Logikpegel der MSB-Leitung des Zählerausgangs (Ct1) dient zugleich als Abtastsignal mit der Abtastfrequenz fs = $fc/2^N$.

6. Monolithisch integrierter D/A-Wandler nach Anspruch 1, gekennzeichnet durch folgende Merkmale:
- das zyklische Schiebenetzwerk (Sn) ist ein rückgekoppeltes drittes Schieberegister (Sr3) mit $2^{N+1}$ Schiebestufen, ebensovielen Eingängen und ebensovielen Ausgängen,
- die Stellenzahl des dualen Eingangssignals (Ed) ist N + l,
- die Anzahl der Schiebestufen des rückgekoppelten dritten Schieberegisters (Sr3) ist gleich dem $2^{N+1}$-fachen Verhältnis aus Taktfrequenz (fc) zu Abtastfrequenz (fs),

- das vom Abtastsignal gesteuerte Einschreiben in das rückgekoppelte dritte Schieberegister (Sr3) erfolgt alternierend in der Weise, daß
  - in dem einen Abtasttakt in die erste Hälfte des dritten Schieberegisters (Sr3) lauter H- oder L-Pegel entsprechend dem MSB-Wert des Eingangssignals (Ed) und in die andere Hälfte der Thermometercode des von der MSB-Stelle abgestreiften Eingangssignal (Ed) eingeschrieben wird und
  - in dem anderen Abtasttakt die erste und die zweite Hälfte des dritten Schieberegisters (Sr3) gegenüber dem ersten Abtasttakt vertauscht eingeschrieben werden, es sei denn, daß ein MSB-Sprung im Eingangssignal (Ed) vorliegt.

7. Monolithisch integrierter D/A-Wandler nach Anspruch 6, dadurch gekennzeichnet, daß das alternierende Einschreiben in die beiden Hälften des dritten Schieberegisters (Sr3) durch einen Kreuzschalter erfolgt.

8. Monolithisch integrierter D/A-Wandler nach Anspruch 7 und 5, gekennzeichnet durch folgende Merkmale:
   - der Kreuzschalter (Ks) ist an seinem ersten Eingang (E1) mit dem MSB-Signal des Eingangssignals (Ed) und an seinem zweiten Eingang (E2) mit dem Ausgangssignal des Komparators (Km) gespeist, dessen Minuendeingang (A) die N Stellen des von der MSB-Stelle abgestreiften (N + 1)-stelligen Eingangssingals (Ed) zugeführt sind,
   - der erste Ausgang des Kreuzschalters (Ks) speist den Serieneingang (In) eines ersten Schieberegisters (Sr1), dessen $2^N$ Ausgänge mit den $2^N$ Eingängen der ersten Hälfte des dritten Schieberegisters (Sr3) verbunden sind,
   - der zweite Ausgang des Kreuzschalters (Ks) speist den Serieneingang (In) eines zweiten Schieberegisters (Sr2), dessen $2^N$ Ausgänge mit den $2^N$ Eingängen der zweiten Hälfte des dritten Schieberegisters (Sr3) verbunden sind,
   - die parallele Übernahme der Inhalte des ersten und des zweiten Schieberegisters (Sr1, Sr2) in das dritte Schieberegister (Sr3) wird durch das Abtastsignal am Ladeeingang (Ld) des dritten Schieberegisters (Sr3) gesteuert.

**Claims**

1. Monolithic integrated digital-to-analog converter ( = D/A converter) comprising
   - a number of inputs which, controlled by a sampling signal, accept a multibit digital input signal (Ed) at the frequency (fs) of said sampling signal,
   - current-source units of which a number corresponding to the value of the digital input signal are connected by means of bit switches to a summing stage whose output (Aa) is the output of the D/A converter,
   - a clock signal whose frequency (fc) is a multiple of the sampling frequency (fs) and which successively switches all of said current-source units within one sampling period in such a way that said current-source units are on for exactly the same duration in said sampling period, and
   a cyclic shift network (Sn) having at least m outputs, where m is the greatest possible numerical value of the input signal (Ed), with the control electrode of the bit switch of each current-source unit driven by the associated stage of the shift network (Sn),

   characterized in
   - that the input signal (Ed) is applied to the inputs of a code converter (Cw) which converts it to a Code with a, preferably continuous, number of first binary states which is equal to the numerical value of the input signal (Ed),
   - that the outputs of the code converter (Cw) are coneted to the inputs of the cyclic shift network (Sn),
   - that the cyclic shift network (Sn) has at least m in-puts, and
   - that the number of stages of the cyclic shift network (Sn) is equal to the ratio of the clock frequency (fc) to the sampling frequency (fs), the latter being derived by dividing the frequency of the clock signal by means of a divider (D).

2. A monolithic integrated D/A converter as claimed in claim 1 wherein the cyclic shift network (Sn) is implemented in the known manner with a feedback shift register (Sr).

3. A monolithic integrated D/A converter as claimed in claim 2, characterized in
   - that the ratio of the clock frequency (fc) to the sampling frequency (fs) is equal to a power of two $2^N$,

- that the divider (D) is an N-stage binary divider, and
- that the shift register (Sr) consists of $2^N$ shift stages.

4. A monolithic integrated D/A converter as claimed in claim 3, characterized in
   - that for an N-bit binary input signal (Ed), the code converter (Cw') includes an N-bit binary down counter (Ct) which is set to the numerical value of the input signal (Ed) by means of the sampling signal and, by means of logic circuits, delivers pulses at the clock frequency (fc) to a serial input (In) of the shift register (Sr') until its count is zero, and
   - that said pulse sequence fed serially into the input (In) of the shift register (Sr') is transferred in parallel into the shift portion proper under control of the sampling signal, said shift portion being clocked by the clock signal.

5. A monolithic integrated D/A converter as claimed in claim 3, characterized by the following features:
   - The code converter is formed by a comparator (Km) clocked at the clock frequency (fc) and having an N-bit subtrahend input (B) and an N-bit minuend input (A) to which the N-bit binary input signal (Ed) is applied;
   - the divider is an N-bit binary counter (Ct1) which is clocked at the clock frequency (fc) and whose count is fed to the subtrahend input (B) of the comparator (Km), with the output (Ka) of the latter delivering pulses at the clock frequency (fc) to a serial input (In) of the shift register (Sr) until the numerical value of the input signal (Ed) applied at the minuend input (A) is greater than the numerical value of the count applied at the subtrahend input (B);
   - the parallel transfer of the pulse sequence presented to the serial input (In) into the $2^N$-stage shift portion of the shift register (Sr) is controlled by the sampling signal at the load input (Ld), and
   - the logic level of the MSB line of the counter output (Ct1) also serves as the sampling signal with the frequency fs = $fc/2^N$.

6. A monolithic integrated D/A converter as claimed in claim 1, characterized by the following features:
   - The cyclic shift network (Sn) is a feedback third shift register (Sr3) having $2^{N+1}$ shift stages, just as many inputs, and just as many outputs;
   - the number of bits of the binary input signal (Ed) is N + 1;
   - the number of shift stages of the feedback third shift register (Sr3) is equal to $2^{N+1}$, times the ratio of the clock frequency (fc) to the sampling frequency (fs), and
   - the writing into the feedback third shift register (Sr3) under control of the sampling signal is effected alternately such that
     - in one sampling cycle, only H or L levels corresponding to the MSB value of the input signal (Ed) are written into the first half of the third shift register (Sr3) and the thermometer code of the input signal (Ed) stripped of the MSB bit is written into the other half, and
     - in the other sampling cycle, the writing into the first and second halves of the third shift register (Sr3) is interchanged from the first sampling cycle unless an MSB change is present in the input signal (Ed).

7. A monolithic integrated D/A converter as claimed in claim 6, characterized in that the alternate writing into the two halves of the third shift register (Sr3) is accomplished by means of an intermediate switch.

8. A monolithic integrated D/A converter as claimed in claims 7 and 5, characterized by the following features:
   - The intermediate switch (Ks) is supplied at its first input (E1) with the MSB signal of the input signal (Ed) and at its second input (E2) with the output signal from the comparator (Km), whose minuend input (A) is fed with the N bits of the (N + 1)-bit input signal (Ed) stripped of the MSB bit;
   - the first output of the intermediate switch (Ks) feeds the serial input (In) of a first shift register (Sr1) having its $2^N$ outputs connected to the $2^N$ inputs of the first half of the third shift register (Sr3);
   - the second output of the intermediate switch (Ks) feeds the serial input (In) of a second shift register (Sr2) having its $2^N$ outputs connected to the $2^N$ inputs of the second half of the third shift register (Sr3), and
   - the parallel transfer of the contents of the first and second shift registers (Sr1, Sr2) into the third shift register (Sr3) is controlled by the sampling signal at the load input (Ld) of the third shift register (Sr3).

## Revendications

1. Convertisseur numérique/analogique intégré monolithique ( = convertisseur D/A) comportant
   - un certain nombre d'entrées, qui, d'une manière commandée par un signal d'échantillonnage, prennent en charge un signal d'entrée numérique (Ed) à plusieurs chiffres, à la cadence de cette fréquence d'échantillonnage (fs),
   - des unités formant sources de courant, dont un certain nombre, qui correspond à la valeur du signal d'entrée numérique (Ed), sont raccordées au moyen d'interrupteurs de transmission de bits, à un étage additionneur, dont la sortie (Aa) constitue la sortie du convertisseur (D/A),
   - un signal de cadence, dont la fréquence (fc) est égale à un multiple de la fréquence d'échantillonnage (fs) et qui, pendant une période d'échantillonnage, commute successivement toutes les unités formant sources de courant présentes de manière qu'elles soient branchées exactement pendant la même durée au cours de cette période d'échantillonnage, et
   - un réseau à décalage cyclique (Sn), qui possède au moins m sorties, m étant la valeur maximale possible du signal d'entrée (Ed), l'électrode de commande de l'interrupteur de transmission de bits d'une unité formant source de courant étant commandée respectivement par l'étage associé du réseau à décalage (Sn),
   caractérisé par le fait
   - que le signal d'entrée (Ed) est présent aux entrées d'un convertisseur de code (Cw), qui convertit ce signal en un code possédant une suite, notamment continue, de premiers états binaires, dont le nombre est égal à la valeur chiffrée du signal d'entrée (Ed),
   - que les sorties du convertisseur de code (Cw) sont raccordées aux entrées du réseau à décalage cyclique (Sn),
   - que le réseau à décalage cyclique (Sn) possède au moins m entrées, et
   - que le nombre des étages de décalage du réseau à décalage cyclique (Sn) est égal au rapport de la fréquence de cadence (Fc) à la fréquence d'échantillonnage (fs), cette dernière étant obtenue à partir du signal de cadence par division de fréquence au moyen d'un diviseur (D).

2. Convertisseur D/A intégré monolithique selon la revendication 1, caractérisé en ce que le réseau à décalage cyclique (Sn) est réalisé de façon connue par un registre à décalage (Sr) couplé par réaction.

3. Convertisseur D/A intégré monolithique selon la revendication 2, caractérisé en ce que
   - le rapport de la fréquence de cadence (fc) à la fréquence d'échantillonnage (fs) correspond à une puissance de deux $2^N$,
   - le diviseur (D) est un diviseur binaire comportant N étages de division, et
   - le registre à décalage (Sr) est constitué par $2^N$ étages.

4. Convertisseur D/A intégré monolithique selon la revendication 3, caractérisé en ce que
   - pour un signal binaire d'entrée (Ed) comportant N chiffres, le convertisseur de code (Cw') contient un compteur binaire régressif à N positions (Ct), qui est positionné au moyen du signal d'échantillonnage sur la valeur chiffrée du signal d'entrée (Ed) et, au moyen de circuits logiques, délivre des impulsions commandées de façon cadencée avec la fréquence de cadence (fc), à une entrée série (In) du registre à décalage (Sr'), jusqu'à ce que l'état du compteur régressif soit nul,
   - cette suite d'impulsions introduites en série à l'entrée (In) du registre à décalage (Sr') est prise en charge, d'une manière commandée par le signal d'échantillonnage, en parallèle dans la partie de décalage proprement dite commandée de façon cadencée par le signal de cadence.

5. Convertisseur D/A intégré monolithique selon la revendication 3, caractérisé par les caractéristiques suivantes :
   - le convertisseur de code est constitué par un comparateur (Km) commandé de façon cadencée par la fréquence de cadence (fc) et possédant une entrée (B) à N chiffres pour le nombre à soustraire et une entrée (A) à N chiffres pour le minuende, à laquelle est envoyé le signal binaire d'entrée (Ed) à N chiffres,
   - le diviseur est constitué par un compteur binaire à N chiffres (Ct1), qui est commandé de façon cadencée par la fréquence de cadence (fc) et dont l'état de comptage alimente l'entrée (B) du nombre à soustraire du comparateur (Km), dont la sortie (Ka) délivre des impulsions possédant la fréquence de cadence (fc) à une entrée en série (In) du registre à décalage (Sr) tant que la valeur chiffrée du signal d'entrée (Ed) appliqué à l'entrée (A) du minuende est supérieure à la valeur chiffrée de l'état du compteur présent à l'entrée (B) du nombre à soustraire,

- le transfert en parallèle de la suite d'impulsions transmises à l'entrée en série (In) dans la partie de décalage proprement dite à $2^N$ étages du registre à décalage (Sr) est commandé par le signal d'échantillonnage au niveau de l'entrée de chargement (Ld), et

- le niveau logique de la ligne de transmission du bit de poids maximum (MSB) de la sortie (Ct1) du compteur est utilisé simultanément comme signal d'échantillonnage possédant la fréquence d'échantillonnage fs = $fc/2^N$.

6. Convertisseur D/A intégré monolithique selon la revendication 1, caractérisé par les caractéristiques suivantes :
- le réseau à décalage cyclique (Sn) est un troisième registre à décalage à réaction (Sr3) comportant $2^{N+1}$ étages de décalage, autant d'entrées et autant de sorties,
- le nombre de chiffres du signal binaire d'entrée (Ed) est égal à N + 1,
- le nombre des étages de décalage du troisième registre à décalage à réaction (Sr3) est égal à $2^{N+1}$ fois le rapport de la fréquence de cadence (fc) à la fréquence d'échantillonnage (fs),
- l'enregistrement, commandé par le signal d'échantillonnage, dans le troisième registre à décalage à réaction (Sr3) s'effectue alternativement de telle sorte-que
- pendant une cadence d'échantillonnage, uniquement des niveaux H ou L sont enregistrés dans la première moitié du troisième registre à décalage (Sr3) en fonction de la valeur du bit MSB du signal d'entrée (Ed), et le code thermomètre du signal d'entrée (Ed) éliminé de la position du bit MSB est enregistré dans l'autre moitié du registre, et
- pendant l'autre cadence d'échantillonnage, les première et seconde moitiés du troisième registre à décalage (Sr3) sont enregistrées d'une manière permutée par rapport à la première cadence d'échantillonnage, à moins qu'un saut du bit MSB soit présent dans le signal d'entrée (Ed).

7. Convertisseur d'entrée D/A intégré monolithique suivant la revendication 6, caractérisé par le fait que l'enregistrement alterné dans les deux moitiés du troisième registre à décalage (Sr3) est réalisé au moyen d'un interrupteur inverseur.

8. Convertisseur D/A intégré monolithique selon les revendications 7 et 5, caractérisé par les caractéristiques suivantes :
- l'interrupteur inverseur (Ks) est alimenté, au niveau de sa première entrée (E1), par le signal MSB du signal d'entrée (Ed) et, à sa seconde entrée (E2), par le signal de sortie du comparateur (Km), à l'entrée (A) du minuende duquel sont envoyés les N chiffres du signal d'entrée à (N + 1) chiffres, dans lequel le bit MSB a été éliminé,
- la première sortie de l'interrupteur inverseur (Ks) alimente l'entrée en série (In) d'un premier registre à décalage (Sr1), dont les $2^N$ sorties sont raccordées aux $2^N$ entrées de la première moitié du troisième registre à décalage (Sr3),
- la seconde sortie de l'interrupteur inverseur (Ks) alimente l'entrée en série (In) d'un second registre à décalage (Sr2), dont les $2^N$ sorties sont raccordées aux $2^N$ entrées de la seconde moitié du troisième registre à décalage (Sr3),
- le transfert en parallèle des contenus des premier et second registres à décalage (Sr1, Sr2) dans le troisième registre à décalage (Sr3) est commandé par le signal d'échantillonnage appliqué à l'entrée de chargement (Ld) du troisième registre à décalage (Sr3).

FIG. 1

$$f_s = \frac{f_c}{m} = \frac{f_c}{2^N - 1}$$

FIG. 2

FIG. 3

FIG. 4

FIG. 5